Europäisches Patentamt

European Patent Office

Office européen des brevets

(11) Veröffentlichungsnummer: **0 219 920**

**A2**

(12) **EUROPÄISCHE PATENTANMELDUNG**

(21) Anmeldenummer: 86201839.7

(22) Anmeldetag: 22.10.86

(51) Int. Cl.⁴: **H03G 3/34**

(30) Priorität: 24.10.85 DE 3537837

(43) Veröffentlichungstag der Anmeldung:
29.04.87 Patentblatt 87/18

(84) Benannte Vertragsstaaten:
DE FR GB IT NL

(71) Anmelder: **Philips Patentverwaltung GmbH
Billstrasse 80
D-2000 Hamburg 28(DE) DE**
Anmelder: **N.V. Philips' Gloeilampenfabrieken
Groenewoudseweg 1
NL-5621 BA Eindhoven(NL) FRGBITNL**

(72) Erfinder: **Würz, Rainer
Richard-Wagner-Ring 4a
D-6332 Ehringshausen(DE)**

(74) Vertreter: **Kupfermann, Fritz-Joachim et al
Philips Patentverwaltung GmbH Billstrasse
80 Postfach 10 51 49
D-2000 Hamburg 28(DE)**

(54) Schaltungsanordnung für Verstärker zur Störgeräuschunterdrückung bei auf Minimum eingestellter Lautstärke.

(57) Die Erfindung betrifft eine Schaltungsanordnung zur Störgeräuschunterdrückung bei auf Minimum eingestellter Lautstärker eines Niederfrequenzverstärkers, der einen Schaltkreis zur Veränderung der Lautstärke in Abhängigkeit von einer Steuergleichspannung aufweist, welche mittels eines Lautstärkestellers veränderbar ist. Im Signalweg des Verstärkers ist hinter dessen letzter Stufe ein elektrisch angesteuertes Schaltelement angeordnet, mittels dessen der Signalweg in Abhängigkeit von der Steuer-Gleichspannung auftrennbar ist. Die Auftrennung des Signalweges wird bei demjenigen Wert der Steuergleichspannung vorgenommen, der vorhanden ist, wenn die Lautstärke mittels des Lautstärkestellers auf Minimum eingestellt ist.

FIG.1

## Schaltungsanordnung für Verstärker zur Störgeräuschunterdrückung bei auf Minimum eingestellter Lautstärke

Die Erfindung bezieht sich auf eine Schaltungsanordnung zur Störgeräuschunterdrückung bei auf Minimum eingestellter Lautstärke eines Niederfrequenzverstärkers, der einen Schaltkreis zur Veränderung der Lautstärke in Abhängigkeit von einer Steuer-Gleichspannung aufweist, die mittels eines Lautstärkestellers veränderbar ist.

Bei Niederfrequenz-Verstärkern tritt oftmals bei voll zurückgestelltem Lautstärkesteller ein störendes Eigenrauschen des Verstärkers auf. Dieses Eigenrauschen ist besonders stark, wenn zur Lautstärke-und Klangstellung ein aktiver integrierter Schaltkreis verwendet wird, dessen Eigenrauschen insbesondere bei voll zurückgestellter Verstärkung in störender Weise hörbar wird.

Es sind Schaltungsanordnungen für Niederfrequenz-Verstärker bekannt, bei denen die Lautstärkeeinstellung an mehreren Punkten im Verstärker vorgenommen wird. Der dabei eingesetzte Lautstärkesteller weist mehrere Potentiometer auf, die in verschiedene Stufen des Verstärkers eingeschleift werden. Bei derartigen Schaltungsanordnungen muß darüber hinaus der Verstärker für mehrstufige Lautstärke einstellung konzipiert sein, und es sind relativ viele Kabelverbindungen zwischen Potentiometer und Verstärker zu schaffen. Der Schaltungsaufbau ist also relativ aufwendig und macht die Vorteile des Einsatzes eines aktiven integrierten Schaltkreises zur Lautstärkeeinstellung, nämlich den sehr einfachen Schaltungsaufbau, wieder zunichte.

Ferner ist aus der DE-OS 24 60 602 ein Empfänger für hochfrequente magnetische Schwingungen mit Verstärkungsregelung und Überwachungsschaltung bekannt, bei dem im Kreis der automatischen Verstärkungsregelung eine Regelspannung gewonnen wird, um einen mit einer im Weg des Ausgangssignals liegenden Abschalteinrichtung verbundenen Schaltverstärker zu steuern. Es wird also das Aussgangssignal des Empfängers stummgeschaltet, wenn der Empfangspegel einen bestimmten Wert unterschreitet. Als Kriterium für die Größe des Empfangspegels wird eine entsprechende Regelspannung einer automatischen Verstärkungseregelung eingesetzt. Diese Schaltung dient also dazu, den Ausgang stumm zu schalten, wenn das Eingangssignal des HF-Empfängers zu schwach wird. Ähnliche Schaltungen sind auch in anderen Ausführungsformen bekannt und werden im allgemeinen als Muting-Schaltungen bezeichnet.

Es ist Aufgabe der Erfindung, eine möglichst einfache Schaltungsanordnung für einen Niederfrequenz-Verstärker zu schaffen, die bei auf ein Minimum eingestellter Lautstärke das Eigenrauschen des Verstärkers wirksam unterdrückt.

Die Aufgabe wird erfindungsgemäß dadurch gelöst, daß im Signalweg des Verstärkers hinter dessen letzter Stufe ein elektrisch angesteuertes Schaltelement angeordnet ist, mittels dessen der Signalweg in Abhängigkeit von der Steuer-Gleichspannung auftrennbar ist, und daß diese Auftrennung des Signalweges bei dem Wert der Steuer-Gleichspannung vorgenommen wird, der vorhanden ist, wenn die Lautstärke mittels des Lautstärkestellers auf Minimum eingestellt ist.

Auf diese Weise ist gewährleistet, daß bei auf Minimum eingestellter Lautstärke an einem an den Ausgang des Verstärkers geschalteten Lautsprecher kein Eigenrauschen des Verstärkers mehr auftritt. Die Schaltspannung für den elektrisch gesteuerten Schalter kann dabei auf verschiedene Weise gewonnen werden, so kann z. B. an dem Lautstärkesteller ein Schalter vorgesehen sein, der bei voll zurückgestelltem Lautstärkesteller einen Kontakt schließt, so daß der Signalweg mittels des elektrisch gesteuerten Schalters aufgetrennt wird. Eine wirksame Unterdrückung des Rauschens bei auf Minimum eingestellter Lautstärke ist von besonderer Bedeutung, wenn dem Verstärker ein anderer ungeregelter Verstärker zum Erhöhen der maximalen Ausgangsleistung, ein sogenannter Booster, nachgeschaltet ist, da dieser auch bei auf Minimum eingestellter Lautstärke des ersten Verstärkers seine volle Verstärkung hat und so die Störgeräusche des ersten Verstärkers besonders deutlich hörbar werden. Darüber hinaus werden Ein-und Ausschaltknacke wirksam unterdrückt, da der Signalweg bei voll zurückgedrehtem Lautstärkesteller bereits unterbrochen ist.

Insbesondere in Autoradios wird zur Schaltungsvereinfachung und um Platz zu sparen zur Lautstärke-, Balance-und Klangeinstellung oftmals ein aktiver integrierter Schaltkreis eingesetzt. Die Lautstärkeeinstellung wird dabei mittels einer einem Eingang des integrierten Schaltkreises zugeführten Gleichspannung vorgenommen, mittels derer die Verstärkung des integrierten Schaltkreises von z. B. -70 dB bis 0 dB verändert werden kann. Die Auftrennung des Signalweges des Verstärkers mittels des elektrisch gesteuerten Schalters kann nun in Abhängigkeit dieser dem integrierten Schaltkreis zur Lautstärkeeinstellung zugeführten Regel-Gleichspannung vorgenommen werden.

Dies kann z. B. nach einer weiteren Ausgestaltung der Erfindung dadurch geschehen, daß die Steuer-Gleichspannung in einem Komparator mit einer vorgegebenen Referenzspannung verglichen und der Signalweg mittels des elektrisch angesteuerten Schaltmomentes aufgetrennt wird, wenn die Steuer-Gleichsapnnung kleiner als die Referenzspannung ist.

Nach einer weiteren Ausgestaltung der Erfindung ist bei einem Einsatz der Schaltungsanordnung in einem Autoradio mit einer Schaltung zur Unterdrückung des Zwischensenderrauschens in dessen Empfangsteil vorgesehen, daß bei einem Ansprechen der Schaltung der Signalweg mittels des elektrisch gesteuerten Schalters aufgetrennt wird. Auf diese Weise benötigt die Schaltung zur Unterdrückung des Zwischensenderrauschens keine eigenen Mittel zur Auftrennung des Signalweges, sondern kann das der letzten Verstärkerstufe nachgeschaltete elektrisch angesteuerte Schaltelement zur Unterdrückung des Zwischensenderrauschens entsprechend schalten.

Nach einer weiteren Ausgestaltung der Erfindung ist vorgesehen, daß als elektrisch gesteuerter Schalter ein aktives Bauelement, beispielsweise ein Transistor, zur Störgeräuschunterdrückung eingesetzt wird. Durch den Einsatz eines oder mehrerer aktiver Bauelemente zur Störgeräuschunterdrückung kann ein weiches Ein-und Ausschalten erzielt werden, so daß insbesondere bei einem zusätzlichen Einsatz der Schaltung zur Unterdrückung des Zwischensenderrauschens die Ein-und Ausschaltübergänge akustisch nicht störend sind.

Ein Ausführungsbeispiel der Erfindung wird anhand der Zeichnungen näher erläutert. Es zeigen:

Fig. I das Blockschaltbild eines Autoradio-NF-Verstärkers mit einem Relais zur Störgeräuschunterdrückung,

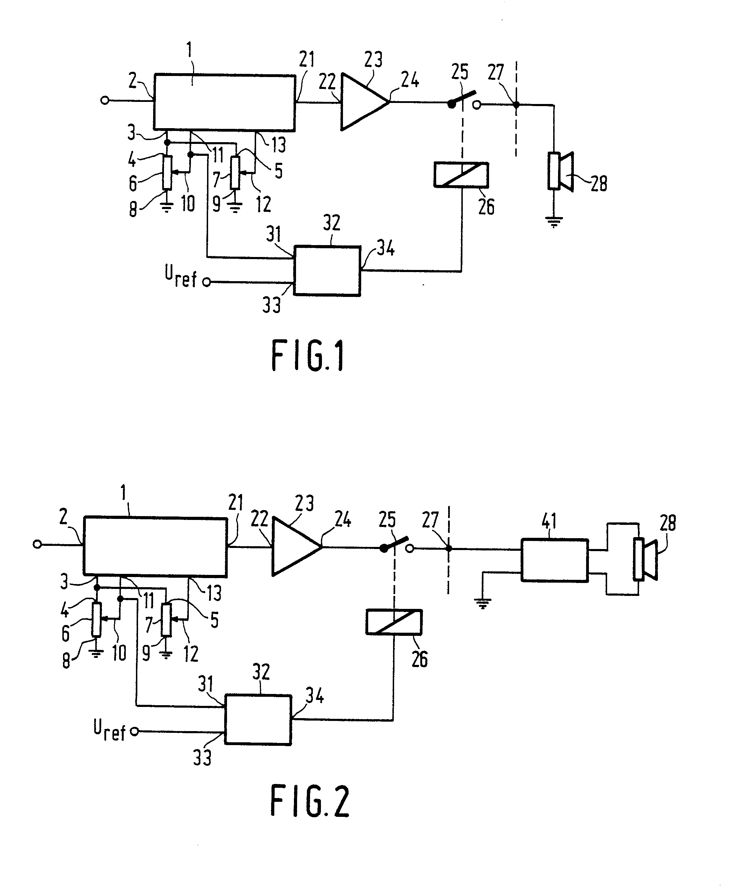

Fig. 2 einen Verstärker nach Fig. I mit zusätzlich nachgeschaltetem externen Verstärker.

Der in Fig. I dargestellte Verstärker eines Autoradios weist eine aktive integrierte Schaltung I auf, mittels derer die Lautstärke-, die Balance-und die Klangeinstellung des Verstärkers vorgenommen wird. Von den vorgeschalteten Verstärkerstufen wird dem integrierten Schaltkreis I an seinem Eingang 2 das zu beeinflussende NF-Signal zugeführt. Der integrierte Schaltkreis I weist einen Ausgang 3 auf, der eine stabilisierte Referenz-Gleichspannung liefert. Diese Referenzspannung wird Endanzapfungen 4 und 5 zweier Potentiometer 6 und 7 zugeführt. Die beiden anderen Endanzapfungen 8 und 9 der Potentiometr 6 und 7 sind auf Masse geführt. Ein Schleifer I0 am Potentiometer 6 ist mit einem Eingang II des integrierten Schaltkreises I verbunden. Diesem Eingang II wird je nach Position des Schleifers I0 des Potentiometers 6 eine mehr oder weniger große Gleichspannung zugeführt. In Abhängigkeit von dieser Gleichspannung wird in dem integrierten Schaltkreis die Verstärkung des ihm an seinem Eingang 2 zugeführten NF-Signals verändert. Ein Schleifer I2 am zweiten Potentiometer 7 ist mit einem weiteren Eingang I3 des integrierten Schaltkreises I zugeführt. In Abhängigkeit der Schleiferstellung am Potentiometer 7 wird also auch diesem Eingang I3 eine variable Gleichspannung zugeführt, mittels derer eine Beeinflussung des NF-Signals, z. B. seines Frequenzganges, in dem integrierten Schaltkreis vorgenommen wird. Im allgemeinen werden insgesamt vier Potentiometer vorgesehen sein, die entsprechend den Potentiometern 6 und 7 verschaltet sind und die der Einstellung der Lautstärke, der Balance, der Bässe und der Höhen dienen.

Das auf diese Weise in seinem Pegel veränderte bzw. beeinflußte NF-Signal liegt an einem Ausgang 2I des integrierten Schaltkreises I an, von dem aus es einem Eingang 22 einer Verstärkerstufe 23 zugeführt wird. Ein Ausgang 24 der Verstärkerstufe 23 ist über einen Relaiskontakt 25 eines Relais 26 einem Lautsprecheranschluß 27 des Verstärkers zugeführt. Zur akustischen Wiedergabe der NF-Signale ist an den Lautsprecheranschluß 27 ein Lautsprecher 28 geschaltet.

Zur Störgeräuschunterdrückung bei mittels des Lautstärkestellers 6 auf Minimum eingestellter Lautstärke wird die am Schleiferanschluß I0 des Potentiometers 6 anliegende und dem Eingang II des integrierten Schaltkreises zur Lautstärkeinstellung zugeführte Steuer-Gleichspannung einem ersten Eingang 3I eines Komparators 32 zugeführt. An einen zweiten Eingang 33 des Komparators 32 wird eine Referenz-Gleichspannung angelegt. Der Komparator 32 vergleicht die seinen beiden Eingängen 3I und 33 zugeführten Spannungen und liefert an seinem Ausgang 34 immer dann eine Schaltspannung, wenn die seinem Eingang 3I vom Schleifer I0 des Potentiometers 6 abgegriffene Steuerspannung kleiner ist als die seinem Eingang 33 zugeführte Referenzspannung. Die Schaltspannung des Ausganges 34 des Komparators 33 wird dem Relais 26 zugeführt, mittels dessen Kontakt 25 der Signalweg des Verstärkers zwischen der Verstärkerstufe 23 und dem Lautsprecheranschluß 27 aufgetrennt wird.

Die dem Komparator 32 an seinem Eingang 33 zugeführte Referenzspannung ist so zu wählen, daß das Relais 26 den Signalweg auftrennt, wenn das Potentiometer 6 auf minimale Lautstärke eingestellt ist. Die Referenzspannung kann aber auch extern oder intern veränderbar sein, so daß z. B. in Abhängigkeit des Wirkungsgrades des Lautsprechers oder bei weiteren nachgeschalteten Verstärkerstufen die Stellung des Potentiometers I0, bei der mittels des Relais 26 der Signalweg aufgetrennt wird, einstellbar ist.

In Fig. 2 ist die Schaltungsanordnung nach Fig. I ergänzt durch einen zusätzlichen Verstärker 4I, der zwischen den Lautsprecheranschluß 27 des Verstärkers und den Lautsprecher 28 geschaltet ist. Derartige ungeregelte Nachsatzverstärker werden häufig den Lautsprecheranschlüssen von Autoradios nachgeschaltet, um eine höhere Ausgangsleistung für den Lautsprecher zu erzielen. Diese nachgeschalteten Verstärker, sogenannte Booster, haben ständig volle Verstärkung, was zur Folge hat, daß das Eigenrauschen des Verstärkers, insbesondere bei mittels des Lautstärkestellers 6 auf Minimum eingestellter Lautstärke des Autoradios, besonders störend in Erscheinung tritt, so daß in diesen Fällen eine Unterdrückung der Störgeräusche des Autoradioverstärkers bei auf Minimum eingestellter Lautstärke von besonderer Bedeutung ist.

## Ansprüche

I. Schaltungsanordnung zur Störgeräuschunterdrückung bei auf Minimum eingestellter Lautstärke eines Niederfrequenzverstärkers, der einen Schaltkreis zur Veränderung der Lautstärke in Abhängigkeit von einer Steuer-Gleichspannung aufweist, die mittels eines Lautstärkestellers (I9) veränderbar ist, dadurch gekennzeichnet, daß im Signalweg des Verstärkers hinter dessen letzter Stufe (23) ein elektrisch angesteuertes Schaltelement (26) angeordnet ist, mittels dessen der Signalweg in Abhängigkeit von der Steuer-Gleichspannung auftrennbar ist, und daß diese Auftrennung des Signalweges bei dem Wert der Steuer-Gleichspannung vorgenommen wird, der vorhanden ist, wenn die Lautstärke mittels des Lautstärkestellers (I0) auf Minimum eingestellt ist.

2. Schaltungsanordnung nach Anspruch I, dadurch gekennzeichnet, daß die Steuer-Gleichspannung in einem Komparator (32) mit einer vorgegebenen Referenzspannung verglichen und der Signalweg mittels des elektrisch angesteuerten Schaltelementes (26) aufgetrennt wird, wenn die Steuer-Gleichspannung kleiner als die Referenzspannung ist.

3. Schaltungsanordnung nach Anspruch I oder Anspruch 2, dadurch gekennzeichnet, daß beim Abschalten des Verstärkers der Signalweg mittels des elektrisch angesteuerten Schalters (26) aufgetrennt wird.

4. Schaltungsanordnung nach einem oder mehreren der Ansprüche I bis 3 in einem Autoradio mit einer Schaltung zum Unterdrücken des Zwischensenderrauschens in dessen Empfangsteil, dadurch gekennzeichnet, daß bei einem Ansprechen der Schaltung zum Unterdrücken des Zwischensenderrauschens der Signalweg mittels des elektrisch gesteuerten Schalters (26) aufgetrennt wird.

5. Schaltungsanordnung nach einem oder mehreren der Ansprüche I bis 4, dadurch gekennzeichnet, daß der elektrisch gesteuerte Schalter ein Relais ist.

6. Schaltungsanordnung nach einem oder mehreren der Ansprüche I bis 5, dadurch gekennzeichnet, daß der elektrisch gesteuerte Schalter ein aktives, elektronisches Bauelement, beispielsweise ein Transistor, ist.

FIG.1

FIG.2